# EUROPEAN PATENT SPECIFICATION

(11) **EP 4 529 145 B1**
(45) Date of publication and mention of the grant of the patent: **07.10.2026**
(21) Application number: 23909184.6
(22) Date of filing: 11.08.2023
(51) Int. Cl.: H04M 1/02, H04N 23/57

(54) **TERMINAL DEVICE**
ENDGERÄTEVORRICHTUNG
DISPOSITIF TERMINAL

(30) Priority: 29.12.2022 CN 202211709593
(43) Date of publication of application: 26.03.2025
(73) Proprietor: Honor Device Co., Ltd., Shenzhen, Guangdong 518040 (CN)
(72) Inventor: ZHANG, Yulong, Shenzhen, Guangdong 518040 (CN); WANG, Kaiqiang, Shenzhen, Guangdong 518040 (CN); DONG, Qing, Shenzhen, Guangdong 518040 (CN)
(74) Representative: Gill Jennings & Every LLP
(86) International application number: PCT/CN2023/112695
(87) International publication number: WO 2024/139243

(56) References cited:
- EP-A1- 4 075 768
- WO-A1-2021/238416
- CN-U- 206 115 080
- CN-U- 206 728 066
- CN-U- 207 410 590
- CN-U- 207 518 945
- CN-U- 207 518 945
- CN-U- 210 780 916
- CN-U- 210 780 916
- CN-U- 213 717 101

## Description

This application claims priority to Chinese Patent Application No. 202211709593.X, filed with the China National Intellectual Property Administration on December 29, 2022, and entitled "TERMINAL DEVICE".

### TECHNICAL FIELD

This application relates to the field of electronic product technologies, and in particular, to a terminal device.

### BACKGROUND

As a usage rate of using a terminal device such as a mobile phone or a tablet by a user increases, use stability of the terminal device becomes an increasingly important evaluation indicator. However, in a use process of some terminal devices, phenomena such as a crash and automatic shutdown occur sometimes, which reduces use stability of the terminal devices.

Relevant background art can be found in the following documents:
CN 210 780 916 U (SHENZHEN TECNO TECH CO LTD) 16 June 2020 (2020-06-16); CN 207 518 945 U (NANJING YUEXUN ELECTRONIC TECH CO LTD ET AL.) 19 June 2018 (2018-06-19); as well as in CN 207 410 590 U (GUANGDONG OPPO MOBILE TELECOMMUNICATIONS CORP LTD) 25 May 2018 (2018-05-25).

### SUMMARY

This application provides a terminal device, to help improve use stability. The invention is defined by the appended claims. Embodiments outside the scope of the claims are for illustrative purposes.

### BRIEF DESCRIPTION OF DRAWINGS

FIG. 1 is an exploded view of an embodiment of a terminal device in a forming process of this application;
FIG. 2 is a front view of an embodiment of a terminal device in a forming process of this application;
FIG. 3 is a cross-sectional view at an M-M location in FIG. 2;
FIG. 4 is an exploded view of an embodiment of a terminal device according to this application;
FIG. 5 is a three-dimensional view of a flexible printed circuit board in an embodiment of a terminal device according to this application;
FIG. 6 is a front view of an embodiment of a terminal device according to this application;
FIG. 7 is a cross-sectional view at an A1-A1 location in FIG. 6;
FIG. 8 is a partial enlarged view at A2 in FIG. 7;
FIG. 9 is a three-dimensional view of a connection frame body in an embodiment of a terminal device according to this application;
FIG. 10 is a front view of a connection frame body in an embodiment of a terminal device according to this application;
FIG. 11 is a cross-sectional view at an A3-A3 location in FIG. 10;
FIG. 12 is a schematic diagram in which a first component group is spaced apart from a third component group according to an embodiment of this application;
FIG. 13 is an exploded view of another embodiment of a terminal device according to this application;
FIG. 14 is a three-dimensional view of a flexible printed circuit board in another embodiment of a terminal device according to this application;
FIG. 15 is a front view of another embodiment of a terminal device according to this application;
FIG. 16 is a cross-sectional view at a B1-B1 location in FIG. 15;
FIG. 17 is a cross-sectional view at a B2-B2 location in FIG. 15;
FIG. 18 is a three-dimensional view of a connection frame body in another embodiment of a terminal device according to this application;
FIG. 19 is a front view of a connection frame body in another embodiment of a terminal device according to this application;
FIG. 20 is a cross-sectional view at a B3-B3 location in FIG. 19;
FIG. 21 is a schematic diagram in which a first component group is spaced apart from a third component group according to another embodiment of this application;
FIG. 22 is a front view of a connection ring in still another embodiment of a terminal device according to this application;
FIG. 23 is a schematic diagram of mounting a connection ring in still another embodiment of a terminal device according to this application; and
FIG. 24 is a schematic diagram of a flexible printed circuit board in still another embodiment of a terminal device according to this application.

### DESCRIPTION OF EMBODIMENTS

The terms "first", "second", "third", and the like in the specification, claims, and accompanying drawings of this application are used to distinguish between different objects, but are not used to limit a specific sequence.

In the embodiments of this application, words such as "example" or "for example" are used to represent giving an example, an illustration, or a description. Any embodiment or design solution described as "example" or "for example" in the embodiments of this application should not be explained as being preferred or advantageous over other embodiments or design solutions. Exactly, use of the words such as "example" or "for example" is intended to present related concepts in a specific manner.

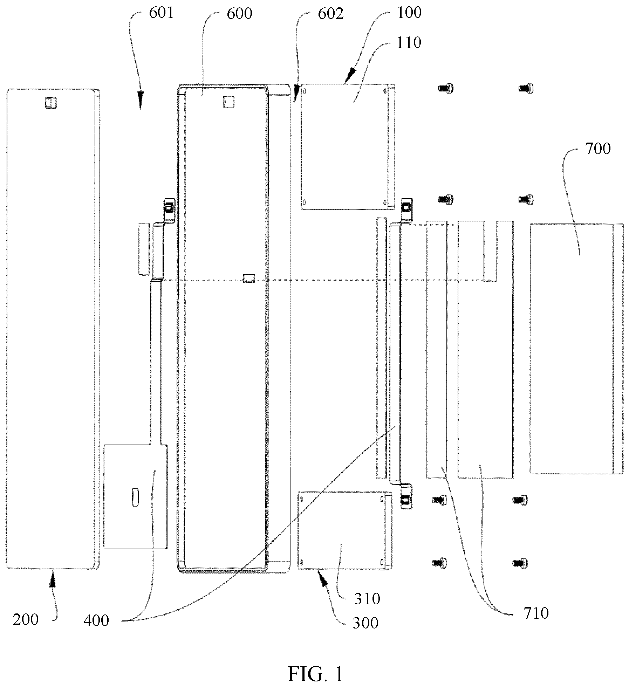

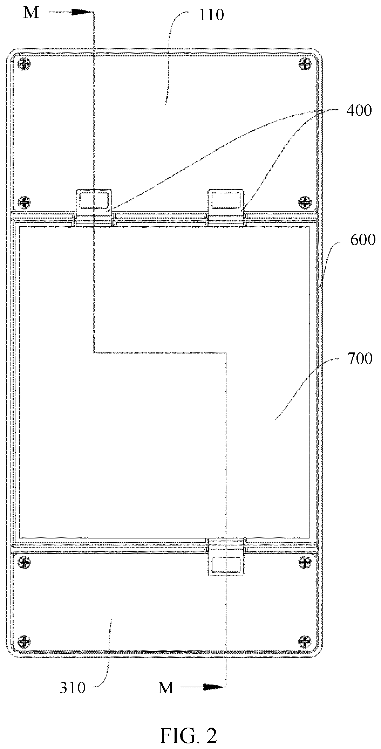

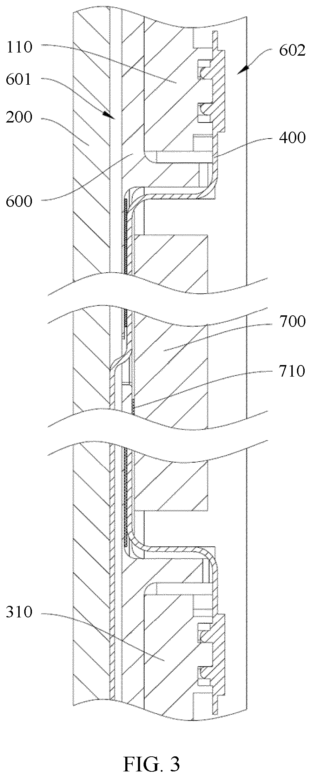

In a forming process of this application, a terminal device shown in FIG. 1 to FIG. 3 is formed. The terminal device includes a connection frame body 600, and the connection frame body 600 has a first side 601 (a left side in FIG. 1) and a second side 602 (a right side in FIG. 1) that are provided opposite to each other. A second component group 200 (which is specifically set as a display screen assembly) is disposed on the first side 601. Both a first component group 100 (which may specifically include a first circuit board 110, where at least one selected from a processor chip, a baseband chip, a radio frequency assembly, and a camera assembly is disposed on the first circuit board 110, and in this case, the first circuit board 110 may be referred to as a mainboard) and a third component group 300 (which may specifically include a second circuit board 310, where at least one of a speaker, a motor, and a data interface is disposed on the second circuit board 310, and in this case, the second circuit board 310 may be referred to as a sub-board) are disposed on the second side 602.

The terminal device includes two independently disposed flexible printed circuit boards 400, the flexible printed circuit board 400 is an FPC (Flexible printed circuit board), and the flexible printed circuit board 400 includes a substrate and a circuit embedded in the substrate. One end of one of the flexible printed circuit boards 400 is connected to the first circuit board 110, and the other end thereof is connected to the second component group 200 after passing through the connection frame body 600. One end of the other flexible printed circuit board 400 is connected to the first circuit board 110, and the other end thereof is connected to the third component group 300. In this case, both a battery 700 and a corresponding first bonding layer 710 are disposed on the second side 602. A researcher of this application has found that one of reasons for low use stability caused by a crash or automatic shutdown of the terminal device is as follows: Because of a relatively large quantity of flexible printed circuit boards 400, a structural arrangement in the terminal device is relatively complex, the foregoing two flexible printed circuit boards 400 cause assembling interference to the battery 700, the first bonding layer 710 corresponding to the battery 700 is forcibly divided into two parts, and consequently, a bonding area of the battery 700 is reduced, and a bonding effect of the battery 700 is weakened. This degrades connection stability of the battery and stability of an output voltage.

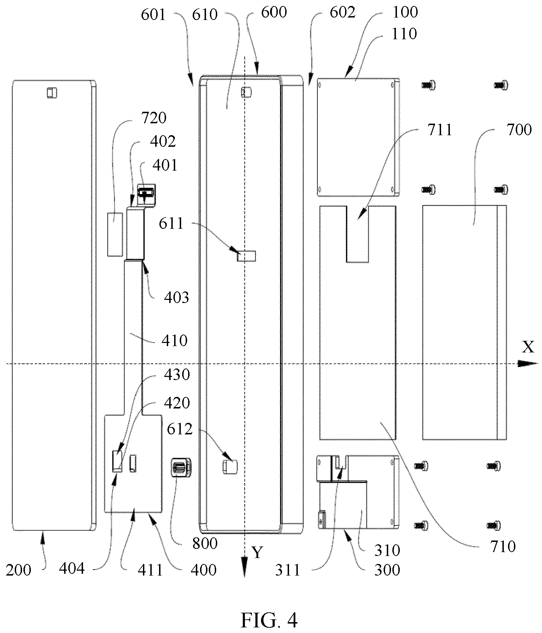

Therefore, this application provides a terminal device, and the terminal device may be set as a mobile phone, a tablet, an electronic watch, or the like. Referring to FIG. 4, the terminal device includes a first component group 100, a second component group 200, a third component group 300, and a flexible printed circuit board 400. The first component group 100 includes a first circuit board 110, and at least one selected from a processor chip, a baseband chip, a radio frequency assembly, and a camera assembly is disposed on the first circuit board 110. In this case, the first circuit board 110 may be referred to as a mainboard. The second component group 200 is set as a display screen assembly. The third component group 300 may be set to include a second circuit board 310, and at least one of a speaker, a motor, and a data interface is disposed on the second circuit board 310. In this case, the second circuit board 310 may be referred to as a sub-board.

Referring to FIG. 4, the terminal device has a first direction and a second direction, the first direction is set as a direction from the first component group 100 to the second component group 200, the first direction intersects the second direction, and the second direction is set to be parallel to a plane of the flexible printed circuit board 400. For the first direction, refer to a Y direction in FIG. 4. For the second direction, refer to an X direction in FIG. 4.

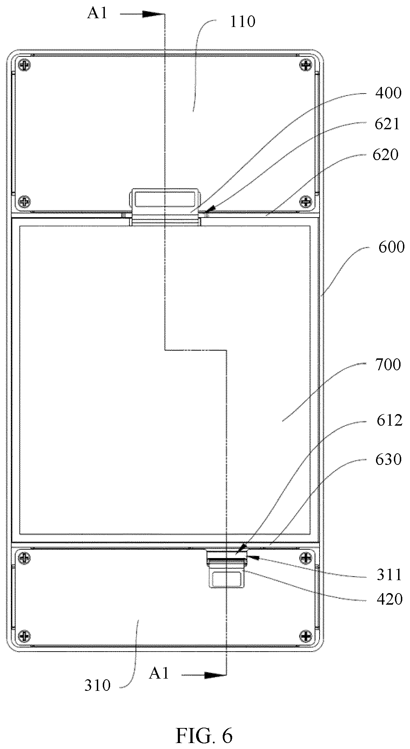

Referring to FIG. 4 to FIG. 7, one end of the flexible printed circuit board 400 is connected to the first circuit board 110, and a first branch 411 and a second branch 420 are disposed on the other end of the flexible printed circuit board 400. The second component group 200 is electrically connected to the first branch 411. The third component group 300 is electrically connected to the second branch 420. The flexible printed circuit board 400 may be specifically connected to the first circuit board 110, the second component group 200, and the second circuit board 310 of the third component group 300 by using a BTB connector.

In this technical solution, the one end of the flexible printed circuit board 400 is connected to the first circuit board 110, the second component group 200 is electrically connected to the first branch 411 at the other end of the flexible printed circuit board 400, and the third component group 300 is electrically connected to the second branch 420 at the other end of the flexible printed circuit board 400, so that the integrated flexible printed circuit board 400 is formed, and a quantity of flexible printed circuit boards 400 is reduced, thereby helping reduce costs. In addition, the reduction in the quantity of flexible printed circuit boards 400 helps simplify a structural arrangement in the terminal device, helps reduce a failure rate of the flexible printed circuit board, reduces assembling interference to the battery 700, helps improve connection stability of the battery 700 and stability of an output voltage, helps reduce a possibility of a crash and automatic shutdown of the terminal device, and helps improve use stability of the terminal device.

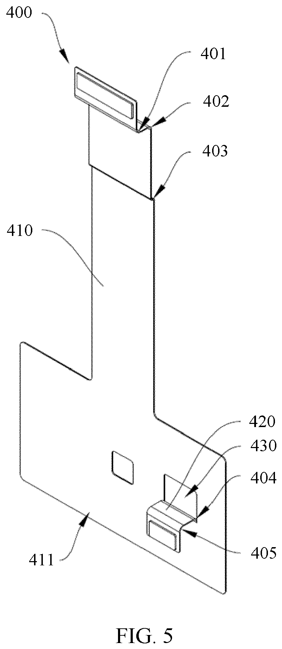

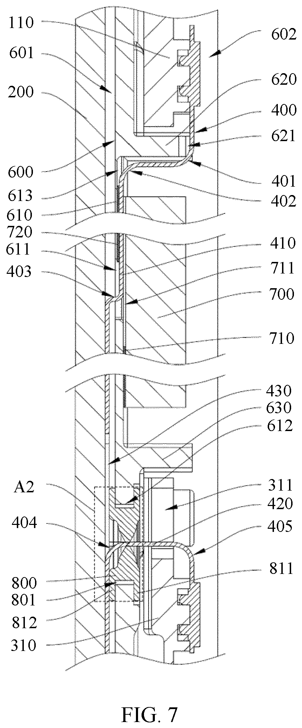

Referring to FIG. 7, the two ends of the flexible printed circuit board 400 may be set to be respectively connected to the first component group 100 and the second component group 200, and the first branch 411 is disposed on an end portion of the flexible printed circuit board 400 facing away from the first component group 100 (as shown in a lower part of FIG. 7). Specifically, with reference to FIG. 5, the flexible printed circuit board 400 includes a main body section 410, two ends of the main body section 410 are respectively connected to the first component group 100 and the second component group 200, and the first branch 411 is disposed on an end portion of the main body section 410 facing away from the first component group 100. Referring to FIG. 5, in the second direction, the second branch 420 is disposed between two side edges of the flexible printed circuit board 400, a first through structure 430 is provided on the flexible printed circuit board 400, the first through structure 430 is provided on the main body section 410, and the second branch 420 is disposed on a sidewall of the first through structure 430, that is, the second branch 420 extends from the sidewall of the first through structure 430. In this case, the first through structure 430 may be set as a through hole. Certainly, the first through structure 430 may alternatively be set as a notch. In this case, the second branch 420 may be disposed on a side edge (a lower side in the figure) of the flexible printed circuit board 400 in the first direction.

Referring to FIG. 4, FIG. 6, and FIG. 7, the terminal device further includes a connection frame body 600. The connection frame body may be set as a middle frame of the terminal device. The connection frame body 600 has a first side 601 (a left side in FIG. 7) and a second side 602 (a right side in FIG. 7) that are provided opposite to each other. The second component group 200 is disposed on the first side 601, and both the first component group 100 and the third component group 300 are disposed on the second side 602. A second through structure 611 and a third through structure 612 are provided on the connection frame body 600, and the second through structure 611 and the third through structure 612 each may be set as a through hole or a notch. This is not limited in this embodiment. One end (an upper end in the figure) of the flexible printed circuit board 400 passes through the second through structure 611 from the first side 601 to be electrically connected to the first component group 100, and the second branch 420 passes through the third through structure 612 from the first side 601 to be electrically connected to the third component group 300. Correspondingly, the terminal device further includes the battery 700 and the first bonding layer 710, and the first bonding layer 710 may be specifically set as a back adhesive or the like. Both the battery 700 and the first bonding layer 710 are disposed on the second side 602. The first component group 100 is spaced apart from the third component group 300, and both the battery 700 and the first bonding layer 710 are disposed between the first component group 100 and the third component group 300. The first bonding layer 710 is disposed between the battery 700 and the connection frame body 600, and two sides of the first bonding layer 710 are respectively bonded to the battery 700 and the connection frame body 600. A second notch 711 is provided on a side of the first bonding layer 710 facing the first component group 100, and the second notch 711 communicates with the second through structure 611. Therefore, the first bonding layer 710 is prevented, by using the second notch 711, from being bonded to the flexible printed circuit board 400 projecting from the second through structure 611.

In this case, a part of the flexible printed circuit board 400 on the first side 601 (the left side in FIG. 7) of the connection frame body can reduce an area of the second notch 711, and increase a bonding area of the first bonding layer 710 to the battery 700, thereby improving bonding stability of the battery 700, connection stability of the battery, and stability of an output voltage, further reducing a possibility of a crash and automatic shutdown of the terminal device, and further improving use stability of the terminal device.

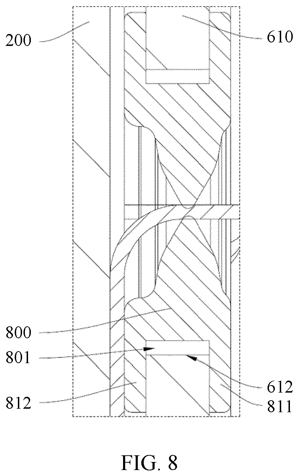

Referring to FIG. 7 and FIG. 8, the connection frame body 600 includes a connection plate 610, and both the second through structure 611 and the third through structure 612 are provided on the connection plate 610. A connection ring 800 is disposed at the third through structure 612, and the connection ring 800 may be specifically made of a material with elasticity, such as rubber. An outer side of the connection ring 800 is connected to the third through structure 612, and an inner side of the connection ring 800 abuts against the flexible printed circuit board 400. Usually, because the terminal device has an insertion/removal structure such as a card tray, there is a risk that liquid and steam are introduced from the insertion/removal structure such as the card tray. In this case, the connection ring 800 can reduce smoothness of flowing of the introduced liquid and the introduced steam along the flexible printed circuit board 400, and alleviate damage to the terminal device caused by the introduced liquid and the introduced steam. Further, the inner side of the connection ring 800 may be set to be in interference fit with the flexible printed circuit board 400, to further improve a blocking capability for the introduced liquid and the introduced steam, and further alleviate damage to the terminal device caused by the introduced liquid and the introduced steam.

Referring to FIG. 8, a first ring plate 811 and a second ring plate 812 are respectively disposed at two ends (left and right ends in FIG. 8) on the outer side of the connection ring 800, and two sides of the connection plate 610 respectively abut against the first ring plate 811 and the second ring plate 812. There is a movable gap 801 between a wall surface of the third through structure 612 and a part of the connection ring 800 between the first ring plate 811 and the second ring plate 812, and the movable gap 801 can enable the connection ring 800 to be more smoothly mounted in the third through structure 612. In addition, the third through structure 612 is usually formed in a manner of mechanical processing, injection molding, casting, or the like, and there may be a burr on the wall surface of the third through structure 612. The movable gap 801 can further reduce a possibility of piercing the connection ring 800 by the burr on the wall surface of the third through structure 612, and reduce a failure risk of the connection ring 800.

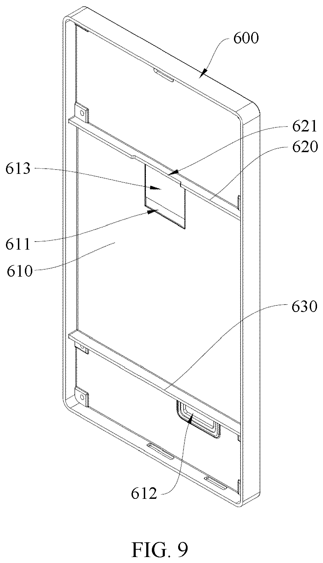

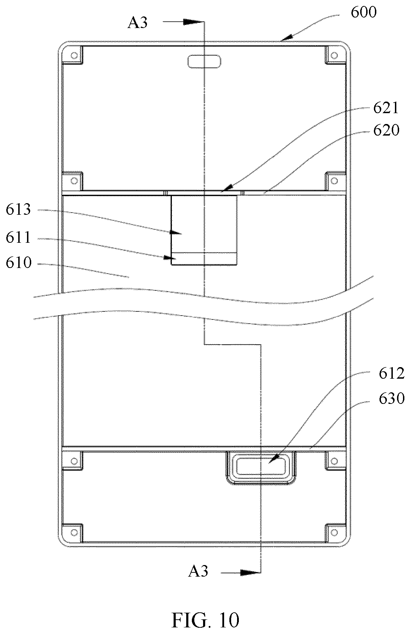

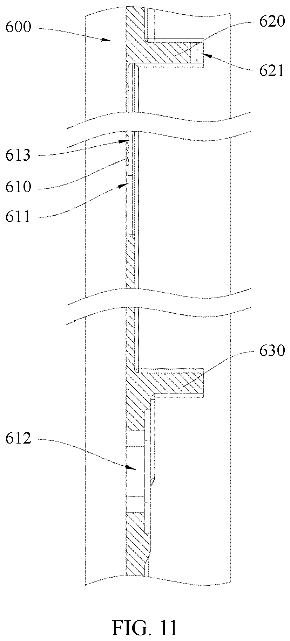

Referring to FIG. 7 and FIG. 9 to FIG. 11, a first vertical plate 620 and a second vertical plate 630 spaced apart from each other are disposed on the second side 602 of the connection plate 610, that is, the first vertical plate 620 and the second vertical plate 630 are in a vertical state relative to the connection plate 610. The first component group 100 is disposed on a side of the first vertical plate 620 facing away from the second vertical plate 630 (for example, disposed on an upper side in FIG. 7), both the battery 700 and the first bonding layer 710 are disposed between the first vertical plate 620 and the second vertical plate 630, and the third component group 300 (including the second circuit board 310) is disposed on a side of the second vertical plate 630 facing away from the first vertical plate 620 (for example, disposed on a lower side in FIG. 7). The second through structure 611 may be provided between the first vertical plate 620 and the second vertical plate 630 (in this case, a distance from the second through structure 611 to the first vertical plate 620 may be further set to be less than a distance from the second through structure 611 to the second vertical plate 630, that is, the second through structure 611 is closer to the first vertical plate 620). Certainly, the second through structure 611 may alternatively be provided on the side of the first vertical plate 620 facing away from the second vertical plate 630. This is not limited in this embodiment. The third through structure 612 is provided on the side of the second vertical plate 630 facing away from the first vertical plate 620 (for example, provided on the lower side in FIG. 7). Alternatively, the third through structure 612 is provided between the first vertical plate 620 and the second vertical plate 630, and a distance from the third through structure 612 to the second vertical plate 630 is less than a distance from the third through structure 612 to the first vertical plate 620 (that is, the third through structure 612 is closer to the second vertical plate 630). This is not limited in this embodiment.

In addition, referring to FIG. 7, FIG. 9, and FIG. 11, while the second through structure 611 is provided between the first vertical plate 620 and the second vertical plate 630, a groove 613 is provided on the connection plate 610, the groove 613 extends in the direction from the first component group 100 to the second component group 200 (in a vertical direction in the figure), and an end portion of the groove 613 is connected to the second through structure 611. In the direction from the first component group 100 to the second component group 200, a part of the flexible printed circuit board 400 is accommodated in the groove 613. The groove 613 can reduce a total thickness of the part of the flexible printed circuit board 400 accommodated in the groove 613 and the connection plate 610, thereby reducing the overall thickness of the terminal device.

To make a connection of a part of the flexible printed circuit board 400 on the second side 602 of the connection frame body 600 more stable, referring to FIG. 7, the terminal device further includes a second bonding layer 720, and the second bonding layer 720 may be set as a back adhesive. The second bonding layer 720 is disposed in the groove 613, and two sides of the second bonding layer 720 are respectively bonded to the flexible printed circuit board 400 and a wall surface of the groove 613. In this case, the second bonding layer 720 is disposed in the groove 613, which also helps reduce the overall thickness of the terminal device by using the groove 613.

Referring to FIG. 7 and FIG. 9 to FIG. 11, a third notch 621 is provided on a side of the first vertical plate 620 facing away from the connection plate 610, and the flexible printed circuit board 400 is at least partially accommodated in the third notch 621 in a thickness direction. The third notch 621 can alleviate scratch damage to the flexible printed circuit board 400, and reduce a stacking thickness of the third notch 621 and the flexible printed circuit board 400, which helps reduce the overall thickness of the terminal device. In addition, a part of the first vertical plate 620 outside the third notch 621 can have a relatively high height, which helps improve structural strength of the first vertical plate 620 and the connection frame body 600.

When the first vertical plate 620 and the second vertical plate 630 are disposed, referring to FIG. 7, a first bent portion 401, a second bent portion 402, and a third bent portion 403 are provided on the flexible printed circuit board 400. The first bent portion 401, the second bent portion 402, and the third bent portion 403 are arranged in the direction from the first component group 100 to the second component group 200. The first bent portion 401 and the second bent portion 402 may be set as L-shaped bends, and the third bend 403 may be set as a Z-shaped bend. There is a first included angle between a part (an upper part in FIG. 7) of the flexible printed circuit board 400 on a side of the first bent portion 401 facing away from the second bent portion 402 and a plate plane of the connection plate 610. For example, the first included angle is 0 degrees, and the part is set to be parallel to the plate plane of the connection plate 610 as a whole. There is a second included angle between a plate plane of the first vertical plate 620 and a part of the flexible printed circuit board 400 between the first bent portion 401 and the second bent portion 402. For example, the second included angle is 0 degrees, and the part is set to be parallel to the plate plane of the first vertical plate 620 as a whole. There is a third included angle between a part of the flexible printed circuit board 400 on a side of the third bent portion 403 facing away from the second bent portion 402 and the plate plane of the connection plate 610. For example, the third included angle is 0 degrees, and the part is set to be parallel to the plate plane of the connection plate 610 as a whole. That is, the first included angle, the second included angle, and the third included angle are set to be greater than or equal to 0 degrees and less than 90 degrees, for example, 0 degrees, 10 degrees, 20 degrees, 45 degrees, or 60 degrees. This is not limited in this embodiment.

Still referring to FIG. 7, a fourth bent portion 404 and a fifth bent portion 405 are provided on the flexible printed circuit board 400, and the fourth bent portion 404 and the fifth bent portion 405 may be set as L-shaped bends. Two ends of the fourth bent portion 404 are respectively connected to the main body section 410 and the second branch 420, and the fifth bent portion 405 is provided on the second branch 420. There is a fourth included angle between a plate plane of the second vertical plate 630 and a part of the second branch 420 between the fourth bent portion 404 and the fifth bent portion 405. For example, the fourth included angle is 0 degrees, and the part is set to be parallel to the plate plane of the second vertical plate 630 as a whole. There is a fifth included angle between a part (a lower right part in FIG. 7) of the second branch 420 on a side of the fifth bent portion 405 facing away from the fourth bent portion 404 and the plate plane of the connection plate 610. For example, the fifth included angle is 0 degrees, and the part is set to be parallel to the plate plane of the connection plate 610 as a whole. That is, both the fourth included angle and the fifth included angle are set to be greater than or equal to 0 degrees and less than 90 degrees, for example, 0 degrees, 10 degrees, 20 degrees, 45 degrees, or 60 degrees. This is not limited in this embodiment.

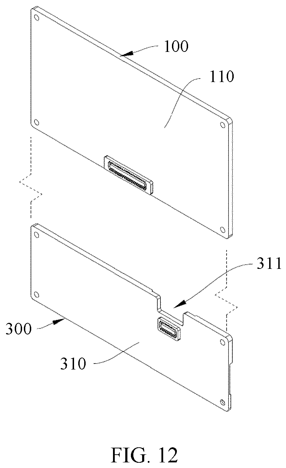

Referring to FIG. 12, a fourth notch 311 is provided on an edge of the second circuit board 310, and the second branch 420 passes through the fourth notch 311 to be connected to the second circuit board 310, to improve the overall compactness of the terminal device.

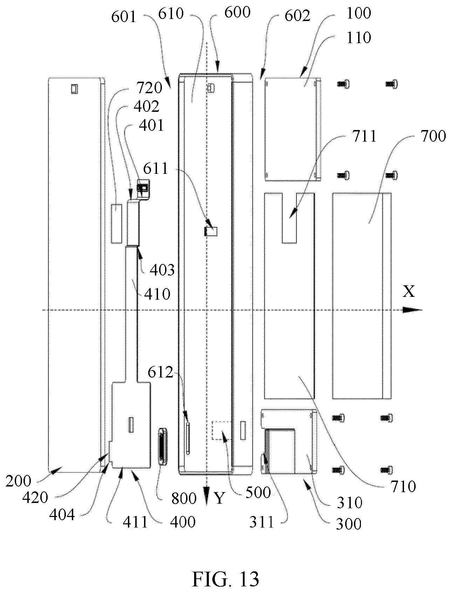

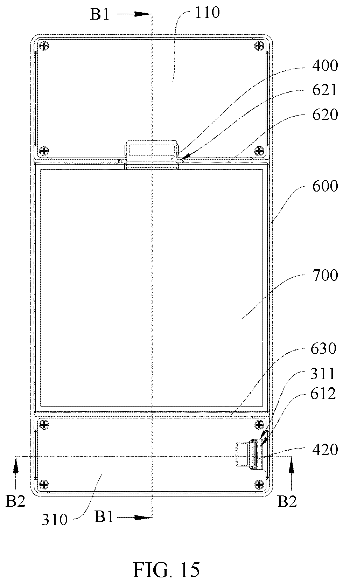

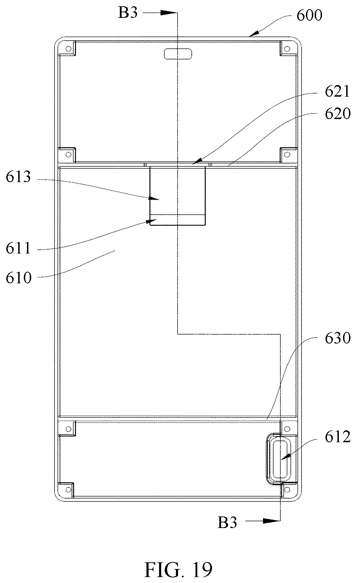

FIG. 13 to FIG. 21 show another embodiment of a terminal device in this application. Referring to FIG. 13, the terminal device includes a first component group 100, a second component group 200, a third component group 300, and a flexible printed circuit board 400. The first component group 100 includes a first circuit board 110, and at least one selected from a processor chip, a baseband chip, a radio frequency assembly, and a camera assembly is disposed on the first circuit board 110. In this case, the first circuit board 110 may be referred to as a mainboard. The second component group 200 is set as a display screen assembly. The third component group 300 may be set to include a second circuit board 310, and at least one of a speaker, a motor, and a data interface is disposed on the second circuit board 310. In this case, the second circuit board 310 may be referred to as a sub-board.

Referring to FIG. 13, the terminal device has a first direction and a second direction, the first direction is set as a direction from the first component group 100 to the second component group 200, the first direction intersects the second direction, and the second direction is set to be parallel to a plane of the flexible printed circuit board 400. For the first direction, refer to a Y direction in FIG. 13. For the second direction, refer to an X direction in FIG. 13.

Referring to FIG. 13 to FIG. 17, one end of the flexible printed circuit board 400 is connected to the first circuit board 110, and a first branch 411 and a second branch 420 are disposed on the other end of the flexible printed circuit board 400. The second component group 200 is electrically connected to the first branch 411. The third component group 300 is electrically connected to the second branch 420. The flexible printed circuit board 400 may be specifically connected to the first circuit board 110, the second component group 200, and the second circuit board 310 of the third component group 300 by using a BTB connector.

In this technical solution, the one end of the flexible printed circuit board 400 is connected to the first circuit board 110, the second component group 200 is electrically connected to the first branch 411 at the other end of the flexible printed circuit board 400, and the third component group 300 is electrically connected to the second branch 420 at the other end of the flexible printed circuit board 400, so that the integrated flexible printed circuit board 400 is formed, and a quantity of flexible printed circuit boards 400 is reduced, thereby helping reduce costs. In addition, the reduction in the quantity of flexible printed circuit boards 400 helps simplify a structural arrangement in the terminal device, helps reduce a failure rate of the flexible printed circuit board, reduces assembling interference to a battery 700, helps improve connection stability of the battery 700 and stability of an output voltage, helps reduce a possibility of a crash and automatic shutdown of the terminal device, and helps improve use stability of the terminal device.

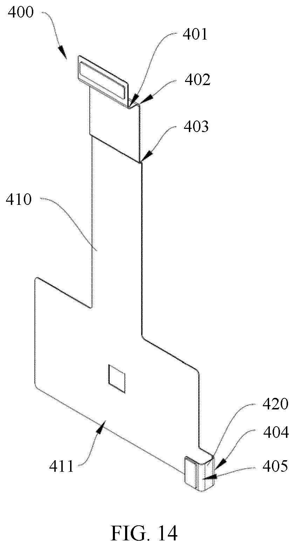

Referring to FIG. 13, the two ends of the flexible printed circuit board 400 may be set to be respectively connected to the first component group 100 and the second component group 200, and the first branch 411 is disposed on an end portion of the flexible printed circuit board 400 facing away from the first component group 100 (as shown in a lower part of FIG. 13). Specifically, with reference to FIG. 14, the flexible printed circuit board 400 includes a main body section 410, two ends of the main body section 410 are respectively connected to the first component group 100 and the second component group 200, and the first branch 411 is disposed on an end portion of the main body section 410 facing away from the first component group 100. In the second direction, the second branch 420 is disposed on a side edge of the flexible printed circuit board 400 (a right side edge shown in FIG. 14).

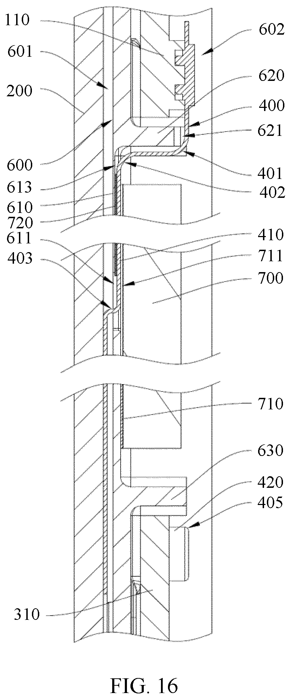

Referring to FIG. 13, FIG. 15, and FIG. 16, the terminal device further includes a connection frame body 600. The connection frame body may be set as a middle frame of the terminal device. The connection frame body 600 has a first side 601 (a left side in FIG. 16) and a second side 602 (a right side in FIG. 16) that are provided opposite to each other. The second component group 200 is disposed on the first side 601, and both the first component group 100 and the third component group 300 are disposed on the second side 602. A second through structure 611 and a third through structure 612 are provided on the connection frame body 600, and the second through structure 611 and the third through structure 612 each may be set as a through hole or a notch. This is not limited in this embodiment. One end (an upper end in the figure) of the flexible printed circuit board 400 passes through the second through structure 611 from the first side 601 to be electrically connected to the first component group 100, and the second branch 420 passes through the third through structure 612 from the first side 601 to be electrically connected to the third component group 300. Correspondingly, the terminal device further includes the battery 700 and a first bonding layer 710, and the first bonding layer 710 may be specifically set as a back adhesive or the like. Both the battery 700 and the first bonding layer 710 are disposed on the second side 602. The first component group 100 is spaced apart from the third component group 300, and both the battery 700 and the first bonding layer 710 are disposed between the first component group 100 and the third component group 300. The first bonding layer 710 is disposed between the battery 700 and the connection frame body 600, and two sides of the first bonding layer 710 are respectively bonded to the battery 700 and the connection frame body 600. A second notch 711 is provided on a side of the first bonding layer 710 facing the first component group 100, and the second notch 711 communicates with the second through structure 611. Therefore, the first bonding layer 710 is prevented, by using the second notch 711, from being bonded to the flexible printed circuit board 400 projecting from the second through structure 611.

In this case, a part of the flexible printed circuit board 400 on the first side 601 (the left side in FIG. 16) of the connection frame body can reduce an area of the second notch 711, and increase a bonding area of the first bonding layer 710 to the battery 700, thereby improving bonding stability of the battery 700, connection stability of the battery, and stability of an output voltage, further reducing a possibility of a crash and automatic shutdown of the terminal device, and further improving use stability of the terminal device.

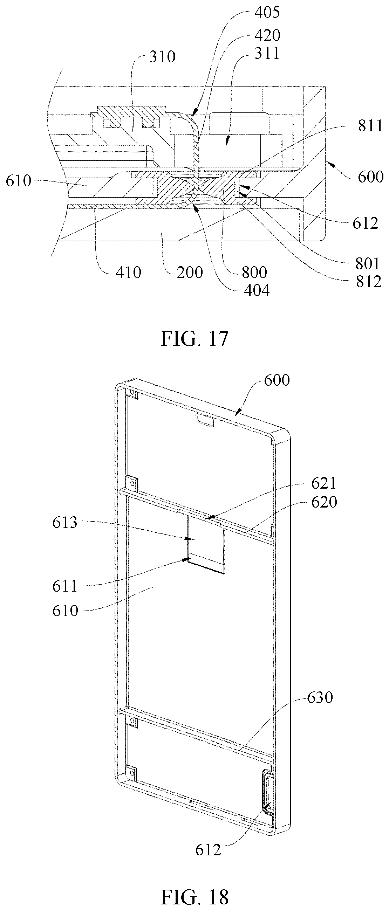

Referring to FIG. 13 and FIG. 17, the connection frame body 600 includes a connection plate 610, and both the second through structure 611 and the third through structure 612 are provided on the connection plate 610. A connection ring 800 is disposed at the third through structure 612, and the connection ring 800 may be specifically made of a material with elasticity, such as rubber. An outer side of the connection ring 800 is connected to the third through structure 612, and an inner side of the connection ring 800 abuts against the flexible printed circuit board 400. Usually, because the terminal device has an insertion/removal structure such as a card tray, there is a risk that liquid and steam are introduced from the insertion/removal structure such as the card tray. In this case, the connection ring 800 can reduce smoothness of flowing of the introduced liquid and the introduced steam along the flexible printed circuit board 400, and alleviate damage to the terminal device caused by the introduced liquid and the introduced steam. Further, the inner side of the connection ring 800 may be set to be in interference fit with the flexible printed circuit board 400, to further improve a blocking capability for the introduced liquid and the introduced steam, and further alleviate damage to the terminal device caused by the introduced liquid and the introduced steam.

Referring to FIG. 17, a first ring plate 811 and a second ring plate 812 are respectively disposed at two ends (upper and lower ends in FIG. 17) on the outer side of the connection ring 800, and two sides of the connection plate 610 respectively abut against the first ring plate 811 and the second ring plate 812. There is a movable gap 801 between a wall surface of the third through structure 612 and a part of the connection ring 800 between the first ring plate 811 and the second ring plate 812, and the movable gap 801 can enable the connection ring 800 to be more smoothly mounted in the third through structure 612. In addition, the third through structure 612 is usually formed in a manner of mechanical processing, injection molding, casting, or the like, and there may be a burr on the wall surface of the third through structure 612. The movable gap 801 can further reduce a possibility of piercing the connection ring 800 by the burr on the wall surface of the third through structure 612, and reduce a failure risk of the connection ring 800.

Referring to FIG. 13 again, the terminal device further includes a communication card mounting portion 500, for example, a corresponding card tray may be disposed. In the second direction, while the second branch 420 is disposed on a side edge of the flexible printed circuit board 400 (for example, disposed on a left side edge in the figure), the communication card mounting portion 500 is disposed on a side of the flexible printed circuit board 400 facing away from the second branch 420 (for example, disposed on a right side in the figure). In this case, the communication card mounting portion 500 is relatively far from the second branch 420 and the corresponding connection ring 800 is relatively far, which helps further reduce smoothness of flowing of the introduced liquid and the introduced steam along the flexible printed circuit board 400, and further alleviate damage to the terminal device caused by the introduced liquid and the introduced steam.

Referring to FIG. 16 and FIG. 18 to FIG. 20, a first vertical plate 620 and a second vertical plate 630 spaced apart from each other are disposed on the second side 602 of the connection plate 610, that is, the first vertical plate 620 and the second vertical plate 630 are in a vertical state relative to the connection plate 610. The first component group 100 is disposed on a side of the first vertical plate 620 facing away from the second vertical plate 630 (for example, disposed on an upper side in FIG. 16), both the battery 700 and the first bonding layer 710 are disposed between the first vertical plate 620 and the second vertical plate 630, and the third component group 300 (including the second circuit board 310) is disposed on a side of the second vertical plate 630 facing away from the first vertical plate 620 (for example, disposed on a lower side in FIG. 16). The second through structure 611 may also be provided between the first vertical plate 620 and the second vertical plate 630 (in this case, a distance from the second through structure 611 to the first vertical plate 620 may be further set to be less than a distance from the second through structure 611 to the second vertical plate 630, that is, the second through structure 611 is closer to the first vertical plate 620). Certainly, the second through structure 611 may alternatively be provided on the side of the first vertical plate 620 facing away from the second vertical plate 630. This is not limited in this embodiment. The third through structure 612 is provided on the side of the second vertical plate 630 facing away from the first vertical plate 620 (for example, provided on a lower side in FIG. 18). Alternatively, the third through structure 612 is provided between the first vertical plate 620 and the second vertical plate 630, and a distance from the third through structure 612 to the second vertical plate 630 is less than a distance from the third through structure 612 to the first vertical plate 620 (that is, the third through structure 612 is closer to the second vertical plate 630). This is not limited in this embodiment.

In addition, referring to FIG. 18 to FIG. 20, while the second through structure 611 is provided between the first vertical plate 620 and the second vertical plate 630, a groove 613 is provided on the connection plate 610, the groove 613 extends in the direction from the first component group 100 to the second component group 200 (in a vertical direction in the figure), and an end portion of the groove 613 is connected to the second through structure 611. In the direction from the first component group 100 to the second component group 200, a part of the flexible printed circuit board 400 is accommodated in the groove 613. The groove 613 can reduce a total thickness of the part of the flexible printed circuit board 400 accommodated in the groove 613 and the connection plate 610, thereby reducing the overall thickness of the terminal device.

To make a connection of a part of the flexible printed circuit board 400 on the second side 602 of the connection frame body 600 more stable, referring to FIG. 16, the terminal device further includes a second bonding layer 720, and the second bonding layer 720 may be set as a back adhesive. The second bonding layer 720 is disposed in the groove 613, and two sides of the second bonding layer 720 are respectively bonded to the flexible printed circuit board 400 and a wall surface of the groove 613. In this case, the second bonding layer 720 is disposed in the groove 613, which also helps reduce the overall thickness of the terminal device by using the groove 613.

Referring to FIG. 16 and FIG. 18 to FIG. 20, a third notch 621 is provided on a side of the first vertical plate 620 facing away from the connection plate 610, and the flexible printed circuit board 400 is at least partially accommodated in the third notch 621 in a thickness direction. The third notch 621 can alleviate scratch damage to the flexible printed circuit board 400, and reduce a stacking thickness of the third notch 621 and the flexible printed circuit board 400, which helps reduce the overall thickness of the terminal device. In addition, a part of the first vertical plate 620 outside the third notch 621 can have a relatively high height, which helps improve structural strength of the first vertical plate 620 and the connection frame body 600.

When the first vertical plate 620 and the second vertical plate 630 are disposed, referring to FIG. 16, a first bent portion 401, a second bent portion 402, and a third bent portion 403 are provided on the flexible printed circuit board 400. The first bent portion 401, the second bent portion 402, and the third bent portion 403 are arranged in the direction from the first component group 100 to the second component group 200. The first bent portion 401 and the second bent portion 402 may be set as L-shaped bends, and the third bent portion 403 may be set as a Z-shaped bend. There is a first included angle between a part (an upper part in FIG. 16) of the flexible printed circuit board 400 on a side of the first bent portion 401 facing away from the second bent portion 402 and a plate plane of the connection plate 610. For example, the first included angle is 0 degrees, and the part is set to be parallel to the plate plane of the connection plate 610 as a whole. There is a second included angle between a plate plane of the first vertical plate 620 and a part of the flexible printed circuit board 400 between the first bent portion 401 and the second bent portion 402. For example, the second included angle is 0 degrees, and the part is set to be parallel to the plate plane of the first vertical plate 620 as a whole. There is a third included angle between a part of the flexible printed circuit board 400 on a side of the third bent portion 403 facing away from the second bent portion 402 and the plate plane of the connection plate 610. For example, the third included angle is 0 degrees, and the part is set to be parallel to the plate plane of the connection plate 610 as a whole. That is, the first included angle, the second included angle, and the third included angle are set to be greater than or equal to 0 degrees and less than 90 degrees, for example, 0 degrees, 10 degrees, 20 degrees, 45 degrees, or 60 degrees. This is not limited in this embodiment.

Referring to FIG. 17, a fourth bent portion 404 and a fifth bent portion 405 are provided on the flexible printed circuit board 400, and the fourth bent portion 404 and the fifth bent portion 405 may be set as L-shaped bends. Two ends of the fourth bent portion 404 are respectively connected to the main body section 410 and the second branch 420, and the fifth bent portion 405 is provided on the second branch 420. There is a fourth included angle between a plate plane of the second vertical plate 630 and a part of the second branch 420 between the fourth bent portion 404 and the fifth bent portion 405. For example, the fourth included angle is 0 degrees, and the part is set to be parallel to the plate plane of the second vertical plate 630 as a whole. There is a fifth included angle between a part (an upper part in FIG. 17) of the second branch 420 on a side of the fifth bent portion 405 facing away from the fourth bent portion 404 and the plate plane of the connection plate 610. For example, the fifth included angle is 0 degrees, and the part is set to be parallel to the plate plane of the connection plate 610 as a whole. That is, both the fourth included angle and the fifth included angle are set to be greater than or equal to 0 degrees and less than 90 degrees, for example, 0 degrees, 10 degrees, 20 degrees, 45 degrees, or 60 degrees. This is not limited in this embodiment.

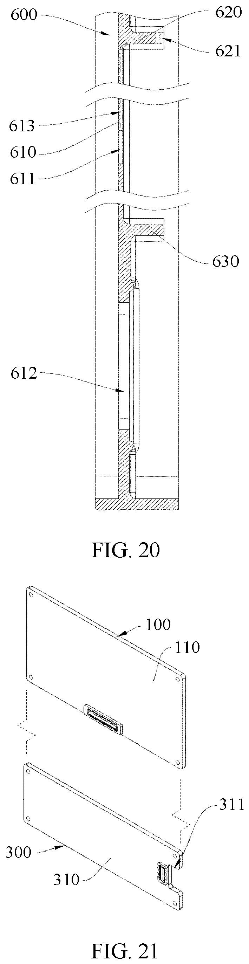

Referring to FIG. 21, a fourth notch 311 is provided on an edge of the second circuit board 310, and the second branch 420 passes through the fourth notch 311 to be connected to the second circuit board 310, to improve the overall compactness of the terminal device.

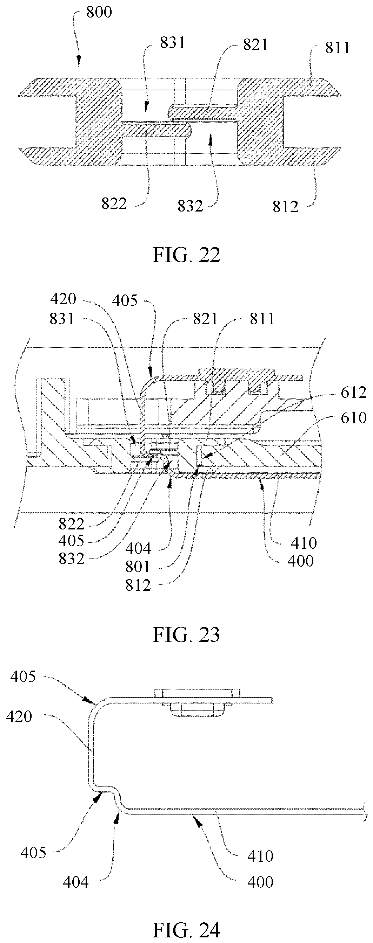

For the foregoing two implementations, referring to FIG. 22 to FIG. 23, the connection ring 800 has the following optional improvement manners.

Referring to FIG. 22 and FIG. 23, a first rib plate 821 is disposed on one side of an inner side surface of the connection ring 800, and a second rib plate 822 is disposed on the other side of the inner side surface of the connection ring 800. A projection of the first rib plate 821 and a projection of the second rib plate 822 at least partially overlap in an axial direction (a vertical direction in the figure) of the connection ring 800, and two sides of the flexible printed circuit board 400 respectively abut against the first rib plate 821 and the second rib plate 822. In this case, the first rib plate 821 and the second rib plate 822 can further block the introduced liquid and the introduced steam flowing along the flexible printed circuit board 400, which helps further alleviate damage to the terminal device caused by the introduced liquid and the introduced steam.

In addition, referring to FIG. 23 and FIG. 24, the flexible printed circuit board 400 has a sixth bent portion 406, and the sixth bent portion 406 may be set as a Z-shaped bend. A sixth included angle is set between each of parts of the flexible printed circuit board 400 on two sides of the sixth bent portion 406 and the axial direction of the connection ring 800. For example, the sixth included angle is 0 degrees, and the part is set to be parallel to the axial direction of the connection ring 800 as a whole. That is, the sixth included angle is greater than or equal to 0 degrees and less than 90 degrees, for example, 0 degrees, 10 degrees, 20 degrees, 45 degrees, or 60 degrees. This is not limited in this embodiment. The parts of the flexible printed circuit board 400 on the two sides of the sixth bent portion 406 are respectively configured to abut against an end portion of the first rib plate 821 and an end portion of the second rib plate 822. In this case, the first rib plate 821 and the second rib plate 822 whose projections at least partially overlap can consume a redundant length of the flexible printed circuit board 400, to improve neatness of an internal structure of the terminal device, and reduce assembling interference of the flexible printed circuit board 400 to another component. The parts of the flexible printed circuit board 400 on the two sides of the sixth bent portion 406 are respectively configured to abut against the end portion of the first rib plate 821 and the end portion of the second rib plate 822, which can reduce a shaking degree of the flexible printed circuit board 400 at this location.

Further, in an optional implementation, referring to FIG. 22 and FIG. 23, there is a first accommodating gap 831 between the end portion of the first rib plate 821 and the inner side surface of the connection ring 800, a width of the first accommodating gap 831 is set in a direction (a horizontal direction in the figure) in which the end portion of the first rib plate 821, the flexible printed circuit board 400, and the inner side surface of the connection ring 800 are sequentially arranged, and the width of the first accommodating gap 831 is greater than or equal to a thickness of the flexible printed circuit board 400. There is a second accommodating gap 832 between the end portion of the second rib plate 822 and the inner side surface of the connection ring 800, a width of the second accommodating gap 832 is set in a direction (the horizontal direction in the figure) in which the end portion of the second rib plate 822, the flexible printed circuit board 400, and the inner side surface of the connection ring 800 are sequentially arranged, and the width of the second accommodating gap 832 is greater than or equal to the thickness of the flexible printed circuit board 400. In this case, when the width of the first accommodating gap 831 is equal to the thickness of the flexible printed circuit board 400, and the width of the second accommodating gap 832 is equal to the thickness of the flexible printed circuit board 400, a shaking degree of the flexible printed circuit board 400 at this location can be further reduced. When the width of the first accommodating gap 831 is greater than the thickness of the flexible printed circuit board 400, and the width of the second accommodating gap 832 is greater than the thickness of the flexible printed circuit board 400, the first accommodating gap 831 and the second accommodating gap 832 can further consume the redundant length of the flexible printed circuit board 400, further improve neatness of the internal structure of the terminal device, and further reduce assembling interference of the flexible printed circuit board 400 to the another component.

Certainly, the connection ring 800 may alternatively be disposed at the second through structure 611 in the foregoing manner, including a connection relationship of providing a movable gap between a wall surface of the second through structure 611 and the part of the connection ring 800 between the first ring plate 811 and the second ring plate 812, and the like. This is not limited in this embodiment.

The foregoing descriptions are merely specific implementations of this application, and any change or replacement readily figured out by a person skilled in the art within the technical scope disclosed in this application shall fall within the protection scope of this application. The protection scope of this application shall be subject to the protection scope of the claims.

## Claims

1. A terminal device, wherein the terminal device comprises:
a first component group (100), wherein the first component group (100) comprises a first circuit board (110), and at least one selected from a processor chip, a baseband chip, a radio frequency assembly, and a camera assembly is disposed on the first circuit board (110);
a flexible printed circuit board (400), wherein one end of the flexible printed circuit board (400) is connected to the first circuit board (110), and a first branch (411) and a second branch (420) are disposed on the other end of the flexible printed circuit board (400);
a second component group (200), wherein the second component group (200) comprises a display screen assembly, and wherein the second component group (200) is electrically connected to the first branch (411); and
a third component group (300), wherein the third component group (300) is electrically connected to the second branch (420);
wherein the terminal device further comprises a connection frame body (600), and the connection frame body (600) has a first side (601) and a second side (602) that are provided opposite to each other;
the second component group (200) is disposed on the first side (601), and both the first component group (100) and the third component group (300) are disposed on the second side (602); and
a second through structure (611) and a third through structure (612) are provided on the connection frame body (600), one end of the flexible printed circuit board (400) passes through the second through structure (611) from the first side (601) to be electrically connected to the first component group (100), and the second branch (420) passes through the third through structure (612) from the first side (601) to be electrically connected to the third component group (300); and
wherein the flexible printed circuit board (400) is connected to the second component group (200) through the first branch (411) on the first side (601) of the connection frame body (600).

2. The terminal device according to claim 1, wherein the terminal device further comprises a battery (700) and a first bonding layer (710), and the battery (700) is disposed on the second side (602); the first component group (100) is spaced apart from the third component group (300), and both the battery (700) and the first bonding layer (710) are disposed between the first component group (100) and the third component group (300); the first bonding layer (710) is disposed between the battery (700) and the connection frame body (600), and two sides of the first bonding layer (710) are respectively bonded to the battery (700) and the connection frame body (600); and a second notch (711) is provided on a side of the first bonding layer (710) facing the first component group (100), and the second notch (711) communicates with the second through structure (611).

3. The terminal device according to claim 2, wherein the connection frame body (600) comprises a connection plate (610), and a first vertical plate (620) and a second vertical plate (630) spaced apart from each other are disposed on a second side (602) of the connection plate (610); the first component group (100) is disposed on a side of the first vertical plate (620) facing away from the second vertical plate (630), both the battery (700) and the first bonding layer (710) are disposed between the first vertical plate (620) and the second vertical plate (630), and the third component group (300) is disposed on a side of the second vertical plate (630) facing away from the first vertical plate (620); and the second through structure (611) is provided on the connection plate (610), and the second through structure (611) is provided between the first vertical plate (620) and the second vertical plate (630), or the second through structure (611) is provided on the side of the first vertical plate (620) facing away from the second vertical plate (630).

4. The terminal device according to claim 3, wherein when the second through structure (611) is provided between the first vertical plate (620) and the second vertical plate (630), a distance from the second through structure (611) to the first vertical plate (620) is less than a distance from the second through structure (611) to the second vertical plate (630).

5. The terminal device according to claim 2, wherein when the second through structure (611) is provided between the first vertical plate (620) and the second vertical plate (630), a groove (613) is provided on the connection plate (610), the groove (613) extends in the direction from the first component group (100) to the second component group (200), and an end portion of the groove (613) is connected to the second through structure (611); and in the direction from the first component group (100) to the second component group (200), a part of the flexible printed circuit board (400) is accommodated in the groove (613).

6. The terminal device according to claim 5, wherein the terminal device further comprises a second bonding layer, the second bonding layer is disposed in the groove (613), and two sides of the second bonding layer are respectively bonded to the flexible printed circuit board (400) and a wall surface of the groove (613).

7. The terminal device according to claim 2, wherein a third notch is provided on a side of the first vertical plate (620) facing away from the connection plate (610), and the flexible printed circuit board (400) is at least partially accommodated in the third notch in a thickness direction.

8. The terminal device according to claim 2, wherein a first bent portion (401), a second bent portion (402), and a third bent portion (403) are provided on the flexible printed circuit board (400), and the first bent portion (401), the second bent portion (402), and the third bent portion (403) are arranged in the direction from the first component group (100) to the second component group (200); and there is a first included angle between a part of the flexible printed circuit board (400) on a side of the first bent portion (401) facing away from the second bent portion (402) and a plate plane of the connection plate (610), there is a second included angle between a plate plane of the first vertical plate (620) and a part of the flexible printed circuit board (400) between the first bent portion (401) and the second bent portion (402), there is a third included angle between a part of the flexible printed circuit board (400) on a side of the third bent portion (403) facing away from the second bent portion (402) and the plate plane of the connection plate (610), and the first included angle, the second included angle, and the third included angle are all set to be greater than or equal to 0 degrees and less than 90 degrees.

9. The terminal device according to claim 2, wherein the flexible printed circuit board (400) comprises a main body section (410), two ends of the main body section (410) are respectively connected to the first component group (100) and the second component group (200), and the first branch (411) is disposed on an end portion of the main body section (410) facing away from the first component group (100); and the third through structure (612) is provided on the connection plate (610), and the third through structure (612) is provided on a side of the second vertical plate (630) facing away from the first vertical plate (620), or the third through structure (612) is provided between the first vertical plate (620) and the second vertical plate (630), and a distance from the third through structure (612) to the second vertical plate (630) is less than a distance from the third through structure (612) to the first vertical plate (620).

10. The terminal device according to claim 9, wherein a fourth bent portion (404) and a fifth bent portion (405) are provided on the flexible printed circuit board (400), two ends of the fourth bent portion (404) are respectively connected to the main body section (410) and the second branch (420), and the fifth bent portion (405) is provided on the second branch (420); and there is a fourth included angle between a plate plane of the second vertical plate (630) and a part of the second branch (420) between the fourth bent portion (404) and the fifth bent portion (405), there is a fifth included angle between a part of the second branch (420) on a side of the fifth bent portion (405) facing away from the fourth bent portion (404) and a plate plane of the connection plate (610), and both the fourth included angle and the fifth included angle are set to be greater than or equal to 0 degrees and less than 90 degrees.

## Patentansprüche

1. Endgerät, wobei das Endgerät umfasst:
eine erste Komponentengruppe (100), wobei die erste Komponentengruppe (100) eine erste Leiterplatte (110) umfasst und wobei mindestens eines aus einem Prozessorchip, einem Basisbandchip, einer Hochfrequenzbaugruppe und einer Kamerabaugruppe auf der ersten Leiterplatte (110) angeordnet ist;
eine flexible Leiterplatte (400), wobei ein Ende der flexiblen Leiterplatte (400) mit der ersten Leiterplatte (110) verbunden ist und ein erster Abzweig (411) sowie ein zweiter Abzweig (420) an dem anderen Ende der flexiblen Leiterplatte (400) angeordnet sind;
eine zweite Komponentengruppe (200), wobei die zweite Komponentengruppe (200) eine Anzeigebildschirmbaugruppe umfasst und wobei die zweite Komponentengruppe (200) elektrisch mit dem ersten Abzweig (411) verbunden ist; und
eine dritte Komponentengruppe (300), wobei die dritte Komponentengruppe (300) elektrisch mit dem zweiten Abzweig (420) verbunden ist;
wobei das Endgerät ferner einen Verbindungsrahmenkörper (600) umfasst, und wobei der Verbindungsrahmenkörper (600) eine erste Seite (601) und eine zweite Seite (602) aufweist, die einander gegenüberliegend vorgesehen sind;
wobei die zweite Komponentengruppe (200) auf der ersten Seite (601) angeordnet ist und sowohl die erste Komponentengruppe (100) als auch die dritte Komponentengruppe (300) auf der zweiten Seite (602) angeordnet sind; und
wobei eine zweite Durchgangsstruktur (611) und eine dritte Durchgangsstruktur (612) an dem Verbindungsrahmenkörper (600) vorgesehen sind, wobei ein Ende der flexiblen Leiterplatte (400) von der ersten Seite (601) aus durch die zweite Durchgangsstruktur (611) verläuft, um elektrisch mit der ersten Komponentengruppe (100) verbunden zu werden, und der zweite Abzweig (420) von der ersten Seite (601) aus durch die dritte Durchgangsstruktur (612) verläuft, um elektrisch mit der dritten Komponentengruppe (300) verbunden zu werden; und
wobei die flexible Leiterplatte (400) durch den ersten Abzweig (411) auf der ersten Seite (601) des Verbindungsrahmenkörpers (600) mit der zweiten Komponentengruppe (200) verbunden ist.

2. Endgerät nach Anspruch 1, **dadurch gekennzeichnet, dass** das Endgerät ferner einen Akku (700) und eine erste Klebeschicht (710) umfasst, und der Akku (700) auf der zweiten Seite (602) angeordnet ist; die erste Komponentengruppe (100) von der dritten Komponentengruppe (300) beabstandet ist und sowohl der Akku (700) als auch die erste Klebeschicht (710) zwischen der ersten Komponentengruppe (100) und der dritten Komponentengruppe (300) angeordnet sind; die erste Klebeschicht (710) zwischen dem Akku (700) und dem Verbindungsrahmenkörper (600) angeordnet ist und zwei Seiten der ersten Klebeschicht (710) jeweils mit dem Akku (700) und dem Verbindungsrahmenkörper (600) verklebt sind; und eine zweite Aussparung (711) an einer der ersten Komponentengruppe (100) zugewandten Seite der ersten Klebeschicht (710) vorgesehen ist, und die zweite Aussparung (711) mit der zweiten Durchgangsstruktur (611) kommuniziert.

3. Endgerät nach Anspruch 2, **dadurch gekennzeichnet, dass** der Verbindungsrahmenkörper (600) eine Verbindungsplatte (610) umfasst, und eine erste vertikale Platte (620) sowie eine zweite vertikale Platte (630), die voneinander beabstandet sind, auf einer zweiten Seite (602) der Verbindungsplatte (610) angeordnet sind; die erste Komponentengruppe (100) auf einer der zweiten vertikalen Platte (630) abgewandten Seite der ersten vertikalen Platte (620) angeordnet ist, sowohl der Akku (700) als auch die erste Klebeschicht (710) zwischen der ersten vertikalen Platte (620) und der zweiten vertikalen Platte (630) angeordnet sind, und die dritte Komponentengruppe (300) auf einer der ersten vertikalen Platte (620) abgewandten Seite der zweiten vertikalen Platte (630) angeordnet ist; und die zweite Durchgangsstruktur (611) an der Verbindungsplatte (610) vorgesehen ist, und die zweite Durchgangsstruktur (611) zwischen der ersten vertikalen Platte (620) und der zweiten vertikalen Platte (630) vorgesehen ist, oder die zweite Durchgangsstruktur (611) an der von der zweiten vertikalen Platte (630) abgewandten Seite der ersten vertikalen Platte (620) vorgesehen ist.

4. Endgerät nach Anspruch 3, **dadurch gekennzeichnet, dass**, wenn die zweite Durchgangsstruktur (611) zwischen der ersten vertikalen Platte (620) und der zweiten vertikalen Platte (630) vorgesehen ist, ein Abstand von der zweiten Durchgangsstruktur (611) zur ersten vertikalen Platte (620) kleiner ist als ein Abstand von der zweiten Durchgangsstruktur (611) zur zweiten vertikalen Platte (630).

5. Endgerät nach Anspruch 2, **dadurch gekennzeichnet, dass**, wenn die zweite Durchgangsstruktur (611) zwischen der ersten vertikalen Platte (620) und der zweiten vertikalen Platte (630) vorgesehen ist, eine Nut (613) in der Verbindungsplatte (610) vorgesehen ist, wobei die Nut (613) sich in der Richtung von der ersten Komponentengruppe (100) zur zweiten Komponentengruppe (200) erstreckt, und ein Endabschnitt der Nut (613) mit der zweiten Durchgangsstruktur (611) verbunden ist; und in der Richtung von der ersten Komponentengruppe (100) zur zweiten Komponentengruppe (200) ein Teil der flexiblen Leiterplatte (400) in der Nut (613) aufgenommen ist.

6. Endgerät nach Anspruch 5, wobei das Endgerät ferner eine zweite Klebeschicht umfasst, wobei die zweite Klebeschicht in der Nut (613) angeordnet ist und zwei Seiten der zweiten Klebeschicht jeweils mit der flexiblen Leiterplatte (400) und einer Wandfläche der Nut (613) verbunden sind.

7. Endgerät nach Anspruch 2, wobei eine dritte Aussparung auf einer der Verbindungsplatte (610) abgewandten Seite der ersten vertikalen Platte (620) vorgesehen ist und die flexible Leiterplatte (400) in einer Dickenrichtung zumindest teilweise in der dritten Aussparung aufgenommen ist.

8. Endgerät nach Anspruch 2, wobei ein erster gebogener Abschnitt (401), ein zweiter gebogener Abschnitt (402) und ein dritter gebogener Abschnitt (403) auf der flexiblen Leiterplatte (400) vorgesehen sind, und der erste gebogene Abschnitt (401), der zweite gebogene Abschnitt (402) und der dritte gebogene Abschnitt (403) in der Richtung von der ersten Komponentengruppe (100) zur zweiten Komponentengruppe (200) angeordnet sind; und ein erster eingeschlossener Winkel zwischen einem Teil der flexiblen Leiterplatte (400) auf einer dem zweiten gebogenen Abschnitt (402) abgewandten Seite des ersten gebogenen Abschnitts (401) und einer Plattenebene der Verbindungsplatte (610) besteht, ein zweiter eingeschlossener Winkel zwischen einer Plattenebene der ersten vertikalen Platte (620) und einem Teil der flexiblen Leiterplatte (400) zwischen dem ersten gebogenen Abschnitt (401) und dem zweiten gebogenen Abschnitt (402) besteht, ein dritter eingeschlossener Winkel zwischen einem Teil der flexiblen Leiterplatte (400) auf einer dem zweiten gebogenen Abschnitt (402) abgewandten Seite des dritten gebogenen Abschnitts (403) und der Plattenebene der Verbindungsplatte (610) besteht, und der erste eingeschlossene Winkel, der zweite eingeschlossene Winkel und der dritte eingeschlossene Winkel alle so eingestellt sind, dass sie größer oder gleich 0 Grad und kleiner als 90 Grad sind.

9. Endgerät nach Anspruch 2, wobei die flexible Leiterplatte (400) einen Hauptkörperabschnitt (410) umfasst, zwei Enden des Hauptkörperabschnitts (410) jeweils mit der ersten Komponentengruppe (100) und der zweiten Komponentengruppe (200) verbunden sind, und der erste Zweig (411) an einem der ersten Komponentengruppe (100) abgewandten Endabschnitt des Hauptkörperabschnitts (410) angeordnet ist; und die dritte Durchgangsstruktur (612) auf der Verbindungsplatte (610) vorgesehen ist, und die dritte Durchgangsstruktur (612) auf einer der ersten vertikalen Platte (620) abgewandten Seite der zweiten vertikalen Platte (630) vorgesehen ist, oder die dritte Durchgangsstruktur (612) zwischen der ersten vertikalen Platte (620) und der zweiten vertikalen Platte (630) vorgesehen ist, und ein Abstand von der dritten Durchgangsstruktur (612) zur zweiten vertikalen Platte (630) kleiner ist als ein Abstand von der dritten Durchgangsstruktur (612) zur ersten vertikalen Platte (620).

10. Endgerät nach Anspruch 9, wobei ein vierter Biegeabschnitt (404) und ein fünfter Biegeabschnitt (405) auf der flexiblen Leiterplatte (400) vorgesehen sind, wobei zwei Enden des vierten Biegeabschnitts (404) jeweils mit dem Hauptkörperabschnitt (410) und dem zweiten Zweig (420) verbunden sind und der fünfte Biegeabschnitt (405) auf dem zweiten Zweig (420) vorgesehen ist; und wobei ein vierter eingeschlossener Winkel zwischen einer Plattenebene der zweiten vertikalen Platte (630) und einem Teil des zweiten Zweigs (420) zwischen dem vierten Biegeabschnitt (404) und dem fünften Biegeabschnitt (405) vorhanden ist, ein fünfter eingeschlossener Winkel zwischen einem Teil des zweiten Zweigs (420) auf einer dem vierten Biegeabschnitt (404) abgewandten Seite des fünften Biegeabschnitts (405) und einer Plattenebene der Verbindungsplatte (610) vorhanden ist, und sowohl der vierte eingeschlossene Winkel als auch der fünfte eingeschlossene Winkel so eingestellt sind, dass sie größer als oder gleich 0 Grad und kleiner als 90 Grad sind.

## Revendications

1. Dispositif terminal, dans lequel le dispositif terminal comprend :
un premier groupe de composants (100), dans lequel le premier groupe de composants (100) comprend une première carte de circuit imprimé (110), et au moins un élément sélectionné parmi une puce de processeur, une puce de bande de base, un ensemble radiofréquence et un ensemble caméra est disposé sur la première carte de circuit imprimé (110) ;
une carte de circuit imprimé flexible (400), dans laquelle une extrémité de la carte de circuit imprimé flexible (400) est connectée à la première carte de circuit imprimé (110), et une première branche (411) et une seconde branche (420) sont disposées sur l'autre extrémité de la carte de circuit imprimé flexible (400) ;
un second groupe de composants (200), dans lequel le second groupe de composants (200) comprend un ensemble écran d'affichage, et dans lequel le second groupe de composants (200) est connecté électriquement à la première branche (411) ; et
un troisième groupe de composants (300), dans lequel le troisième groupe de composants (300) est connecté électriquement à la seconde branche (420) ;
dans lequel le dispositif terminal comprend en outre un corps de cadre de connexion (600), et le corps de cadre de connexion (600) présente un premier côté (601) et un second côté (602) qui sont prévus opposés l'un à l'autre ;
le second groupe de composants (200) est disposé sur le premier côté (601), et à la fois le premier groupe de composants (100) et le troisième groupe de composants (300) sont disposés sur le second côté (602) ; et
une seconde structure traversante (611) et une troisième structure traversante (612) sont prévues sur le corps de cadre de connexion (600), une extrémité de la carte de circuit imprimé flexible (400) passe à travers la seconde structure traversante (611) depuis le premier côté (601) pour être connectée électriquement au premier groupe de composants (100), et la seconde branche (420) passe à travers la troisième structure traversante (612) depuis le premier côté (601) pour être connectée électriquement au troisième groupe de composants (300) ; et
dans lequel la carte de circuit imprimé flexible (400) est connectée au second groupe de composants (200) par l'intermédiaire de la première branche (411) sur le premier côté (601) du corps de cadre de connexion (600).

2. Dispositif terminal selon la revendication 1, dans lequel le dispositif terminal comprend en outre une batterie (700) et une première couche de liaison (710), et la batterie (700) est disposée sur le deuxième côté (602) ; le premier groupe de composants (100) est espacé du troisième groupe de composants (300), et à la fois la batterie (700) et la première couche de liaison (710) sont disposées entre le premier groupe de composants (100) et le troisième groupe de composants (300) ; la première couche de liaison (710) est disposée entre la batterie (700) et le corps de cadre de connexion (600), et deux côtés de la première couche de liaison (710) sont respectivement liés à la batterie (700) et au corps de cadre de connexion (600) ; et une deuxième encoche (711) est prévue sur un côté de la première couche de liaison (710) faisant face au premier groupe de composants (100), et la deuxième encoche (711) communique avec la deuxième structure traversante (611).

3. Dispositif terminal selon la revendication 2, dans lequel le corps de cadre de connexion (600) comprend une plaque de connexion (610), et une première plaque verticale (620) ainsi qu'une deuxième plaque verticale (630) espacées l'une de l'autre sont disposées sur un deuxième côté (602) de la plaque de connexion (610) ; le premier groupe de composants (100) est disposé sur un côté de la première plaque verticale (620) opposé à la deuxième plaque verticale (630), à la fois la batterie (700) et la première couche de liaison (710) sont disposées entre la première plaque verticale (620) et la deuxième plaque verticale (630), et le troisième groupe de composants (300) est disposé sur un côté de la deuxième plaque verticale (630) opposé à la première plaque verticale (620) ; et la deuxième structure traversante (611) est prévue sur la plaque de connexion (610), et la deuxième structure traversante (611) est prévue entre la première plaque verticale (620) et la deuxième plaque verticale (630), ou la deuxième structure traversante (611) est prévue sur le côté de la première plaque verticale (620) opposé à la deuxième plaque verticale (630).

4. Dispositif terminal selon la revendication 3, dans lequel lorsque la deuxième structure traversante (611) est prévue entre la première plaque verticale (620) et la deuxième plaque verticale (630), une distance de la deuxième structure traversante (611) à la première plaque verticale (620) est inférieure à une distance de la deuxième structure traversante (611) à la deuxième plaque verticale (630).

5. Dispositif terminal selon la revendication 2, dans lequel lorsque la deuxième structure traversante (611) est prévue entre la première plaque verticale (620) et la deuxième plaque verticale (630), une rainure (613) est prévue sur la plaque de connexion (610), la rainure (613) s'étend dans la direction allant du premier groupe de composants (100) vers le deuxième groupe de composants (200), et une partie d'extrémité de la rainure (613) est connectée à la deuxième structure traversante (611) ; et dans la direction allant du premier groupe de composants (100) vers le deuxième groupe de composants (200), une partie du circuit imprimé flexible (400) est logée dans la rainure (613).

6. Dispositif terminal selon la revendication 5, dans lequel le dispositif terminal comprend en outre une seconde couche de liaison, la seconde couche de liaison est disposée dans la rainure (613), et deux côtés de la seconde couche de liaison sont respectivement liés à la carte de circuit imprimé flexible (400) et à une surface de paroi de la rainure (613).

7. Dispositif terminal selon la revendication 2, dans lequel une troisième encoche est prévue sur un côté de la première plaque verticale (620) orienté à l'opposé de la plaque de connexion (610), et la carte de circuit imprimé flexible (400) est au moins partiellement logée dans la troisième encoche dans une direction d'épaisseur.

8. Dispositif terminal selon la revendication 2, dans lequel une première partie pliée (401), une seconde partie pliée (402) et une troisième partie pliée (403) sont prévues sur la carte de circuit imprimé flexible (400), et la première partie pliée (401), la seconde partie pliée (402) et la troisième partie pliée (403) sont agencées dans la direction allant du premier groupe de composants (100) au second groupe de composants (200) ; et il existe un premier angle inclus entre une partie de la carte de circuit imprimé flexible (400) sur un côté de la première partie pliée (401) orienté à l'opposé de la seconde partie pliée (402) et un plan de plaque de la plaque de connexion (610), il existe un second angle inclus entre un plan de plaque de la première plaque verticale (620) et une partie de la carte de circuit imprimé flexible (400) entre la première partie pliée (401) et la seconde partie pliée (402), il existe un troisième angle inclus entre une partie de la carte de circuit imprimé flexible (400) sur un côté de la troisième partie pliée (403) orienté à l'opposé de la seconde partie pliée (402) et le plan de plaque de la plaque de connexion (610), et le premier angle inclus, le second angle inclus et le troisième angle inclus sont tous réglés pour être supérieurs ou égaux à 0 degré et inférieurs à 90 degrés.

9. Dispositif terminal selon la revendication 2, dans lequel la carte de circuit imprimé flexible (400) comprend une section de corps principal (410), deux extrémités de la section de corps principal (410) sont respectivement connectées au premier groupe de composants (100) et au second groupe de composants (200), et la première branche (411) est disposée sur une partie d'extrémité de la section de corps principal (410) orientée à l'opposé du premier groupe de composants (100) ; et la troisième structure traversante (612) est prévue sur la plaque de connexion (610), et la troisième structure traversante (612) est prévue sur un côté de la seconde plaque verticale (630) orienté à l'opposé de la première plaque verticale (620), ou la troisième structure traversante (612) est prévue entre la première plaque verticale (620) et la seconde plaque verticale (630), et une distance de la troisième structure traversante (612) à la seconde plaque verticale (630) est inférieure à une distance de la troisième structure traversante (612) à la première plaque verticale (620).

10. Dispositif terminal selon la revendication 9, dans lequel une quatrième partie pliée (404) et une cinquième partie pliée (405) sont prévues sur la carte de circuit imprimé flexible (400), deux extrémités de la quatrième partie pliée (404) sont respectivement connectées à la section de corps principal (410) et à la deuxième branche (420), et la cinquième partie pliée (405) est prévue sur la deuxième branche (420) ; et il existe un quatrième angle inclus entre un plan de plaque de la deuxième plaque verticale (630) et une partie de la deuxième branche (420) située entre la quatrième partie pliée (404) et la cinquième partie pliée (405), il existe un cinquième angle inclus entre une partie de la deuxième branche (420) sur un côté de la cinquième partie pliée (405) opposé à la quatrième partie pliée (404) et un plan de plaque de la plaque de connexion (610), et à la fois le quatrième angle inclus et le cinquième angle inclus sont réglés pour être supérieurs ou égaux à 0 degré et inférieurs à 90 degrés.
